# FASCICULE DE BREVET EUROPEEN

(11) **EP 3 652 768 B1**
(45) Date de publication et mention de la délivrance du brevet: **26.03.2025**
(21) Numéro de dépôt: 17737564.9
(22) Date de dépôt: 10.07.2017
(51) Int. Cl.: H01H 21/06, H02G 3/12, H01H 9/26, H01H 9/28

(54) **APPAREILLAGE ÉLECTRIQUE ET MODULE FONCTIONNEL ADDITIONNEL ASSOCIÉ**
ELEKTRISCHE AUSRÜSTUNG UND DAMIT VERBUNDENES ZUSÄTZLICHES FUNKTIONALES MODUL
ELECTRICAL EQUIPMENT AND ADDITIONAL FUNCTIONAL MODULE ASSOCIATED THEREWITH

(43) Date de publication de la demande: 20.05.2020
(73) Titulaire: Berker GmbH & Co. KG, 58579 Schalksmühle (DE)
(72) Inventeur: NOEL, Pascal, 67370 Wiwersheim (FR); KRAEMER, Jacques, 67000 Strasbourg (FR)
(74) Mandataire: Cabinet Nuss
(86) Numéro de dépôt international: PCT/EP2017/067250
(87) Numéro de publication internationale: WO 2019/011401

(56) Documents cités:
- EP-A1- 1 804 353
- EP-A2- 2 697 813
- WO-A1-2015/038473
- US-A1- 2014 117 859

## Description

La présente invention concerne un appareillage électrique pour une installation électrique et un module fonctionnel additionnel pour cet appareillage électrique. Le document EP2697813A2 divulgue un appareillage électrique de l'état de l'art.

Le document DE 19 21 571 A1 décrit un interrupteur électrique comprenant un élément d'éclairage raccordé en parallèle par rapport au circuit électrique de l'interrupteur électrique pour effectuer une fonction de voyant lumineux. Un tel interrupteur électrique permet uniquement d'effectuer une fonction de voyant lumineux. Par conséquent, cet interrupteur électrique ne permet pas de réaliser des fonctionnalités plus sophistiquées et est donc limité.

La présente invention a pour but de proposer une solution modulable et personnalisable d'appareillage électrique et de pallier les inconvénients de l'art antérieur.

La présente invention concerne un appareillage électrique selon la revendication 1.

L'invention concerne également un module fonctionnel additionnel selon la revendication 8.

L'invention concerne également un assemblage électrique selon la revendication 15.

L'invention sera mieux comprise, grâce à la description ci-après, qui se rapporte à plusieurs modes de réalisation préférés, donnés à titre d'exemples non limitatifs, et expliqués avec référence aux dessins schématiques annexés, dans lesquels :
la figure 1A est une vue en perspective de dessus d'un module fonctionnel primaire selon l'invention,
la figure 1B est une vue en perspective de dessous du module fonctionnel primaire représenté à la figure 1A,
la figure 1C est une vue de dessus du module fonctionnel primaire représenté à la figure 1A,
la figure 2A est une vue en perspective de dessus d'un module fonctionnel additionnel selon l'invention,
la figure 2B est une vue en perspective de dessous du module fonctionnel additionnel représenté à la figure 2A,
la figure 2C est une vue en perspective du détail A représenté à la figure 2B,
la figure 2D est une vue en perspective d'une carte électronique amovible du module fonctionnel additionnel,
la figure 2E est une vue en perspective du module fonctionnel dépourvu de la carte électronique amovible,
la figure 3A est une vue en perspective du module fonctionnel primaire selon l'invention représenté aux figures 1A à 1C associé à un cadre support du module de réception,
la figure 3B est une vue en perspective de l'appareillage électrique selon l'invention comprenant le module fonctionnel primaire selon l'invention représenté aux figures 1A à 1C et le module fonctionnel additionnel représenté aux figures 2A à 2E,
la figure 3C est une vue en perspective d'une plaque de recouvrement selon l'invention,
la figure 3D est une vue en perspective de l'appareillage électrique représenté à la figure 3B et pourvu d'une plaque de recouvrement représentée à la figure 3C,
la figure 4 est une vue de l'appareillage électrique selon l'invention,
la figure 5 est une vue d'un schéma électrique montrant l'assemblage électrique implanté dans une installation électrique,
la figure 6 est une vue d'un schéma électrique montrant le module fonctionnel primaire,
la figure 7 est une vue d'un schéma électrique montrant le module fonctionnel primaire et le module fonctionnel additionnel.

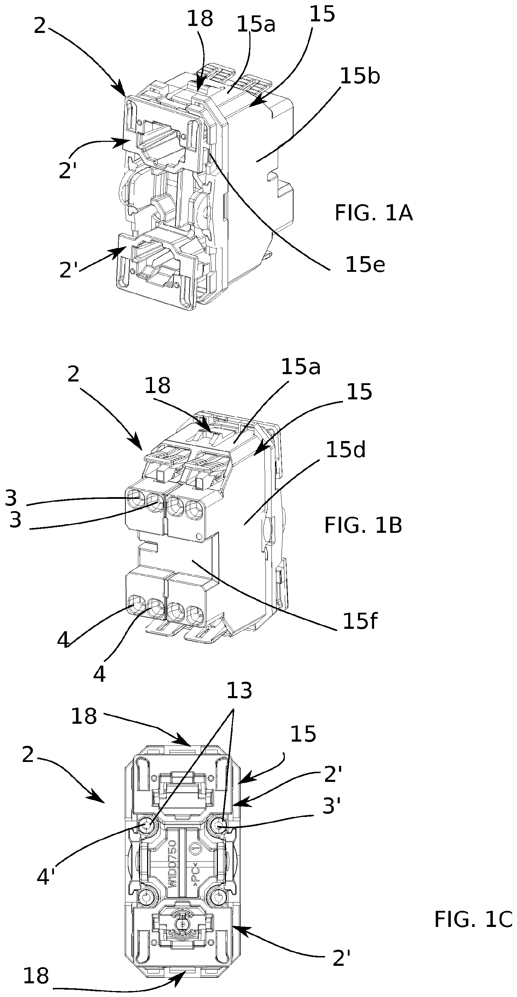

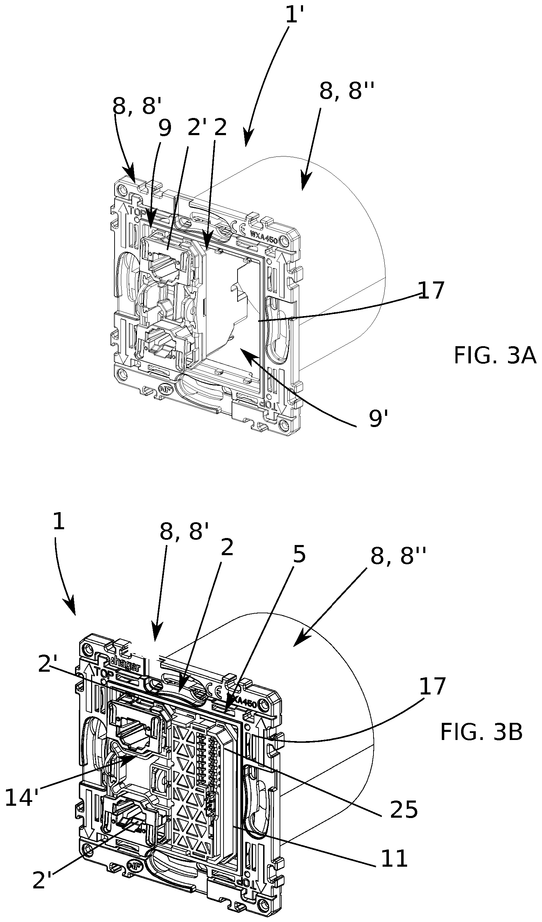

L'appareillage électrique 1' pour une installation électrique apte et destiné à être relié à un réseau électrique, comprend au moins :
- un module de réception 8 comprenant au moins une première zone de réception 9 (figures 3A à 4);
- un module fonctionnel primaire 2 reçu dans la première zone de réception 9 et comprenant un premier pôle de connexion 3 apte et destiné à être relié à une première ligne L du réseau électrique et un deuxième pôle de connexion 4 apte et destiné à être relié à une deuxième ligne L1 d'un circuit électrique de l'installation électrique (figure 1B),

le module fonctionnel primaire 2 (figures 1A et 1C) comprenant un dispositif d'interruption 2" du courant agencé entre le premier pôle de connexion 3 et le deuxième pôle de connexion 4 et apte, dans une position d'ouverture, à interrompre le courant entre le premier pôle de connexion 3 et le deuxième pôle de connexion 4 et, dans une position de fermeture, à permettre le passage du courant entre le premier pôle de connexion 3 et le deuxième pôle de connexion 4,
appareillage électrique 1' caractérisé en ce que le module de réception comprend une deuxième zone de réception 9' pour recevoir un module fonctionnel additionnel 5 (figure 3A) comprenant des moyens pour effectuer au moins une fonction nécessitant une alimentation électrique, le module fonctionnel additionnel 5 comprenant au moins un quatrième pôle de connexion 6 et un cinquième pôle de connexion 7 apte à être reliés électriquement respectivement au premier pôle de connexion 3 et au deuxième pôle de connexion 4 du module fonctionnel primaire 2 pour alimenter le module fonctionnel additionnel 5, et en ce que soit l'appareillage électrique 1' comprend un élément d'interruption étant apte à agir sur le dispositif d'interruption 2" de sorte à interrompre le flux du courant entre le premier pôle de connexion 3 et le deuxième pôle de connexion 4 lorsque le module fonctionnel additionnel 5 est reçu dans la deuxième zone de réception 9', soit un élément d'interruption du module fonctionnel additionnel 5 est apte à agir sur le dispositif d'interruption 2" de sorte à interrompre le flux du courant entre le premier pôle de connexion 3 et le deuxième pôle de connexion 4 lorsque le module fonctionnel additionnel 5 est reçu dans la deuxième zone de réception 9'.

L'élément d'interruption peut donc soit être présent sur l'appareillage l' ou sur le module fonctionnel additionnel 5. Dans ces deux cas, l'élément d'interruption est agencé pour être apte à agir sur le dispositif d'interruption 2" de sorte à interrompre le flux du courant entre le premier pôle de connexion 3 et le deuxième pôle de connexion 4 lorsque le module fonctionnel additionnel 5 est reçu dans la deuxième zone de réception 9'.

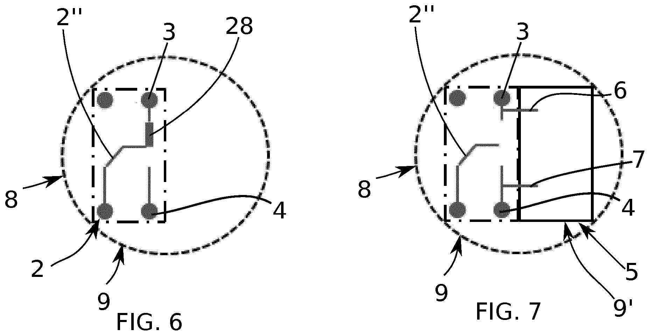

Le dispositif d'interruption 2" peut comprendre en outre un shunt 28 apte à établir le flux du courant entre le premier pôle de connexion 3 et le deuxième pôle de connexion 4 dans une première position et apte à être déplacé depuis la première position vers une deuxième position par l'élément d'interruption lorsque le module fonctionnel additionnel 5 est reçu dans la deuxième zone de réception 9' de sorte à interrompre le flux du courant entre le premier pôle de connexion 3 et le deuxième pôle de connexion 4. Dans ce cas, l'élément d'interruption peut être une tige apte à déplacer le shunt depuis la première position vers la deuxième position à l'encontre d'un ressort. Dans la figure 6, le module fonctionnel additionnel 5 n'est pas reçu dans la deuxième zone de réception 9' et le shunt 28 prend la première position. Dans la figure 7, le module fonctionnel additionnel 5 est reçu dans la deuxième zone de réception 9' et le shunt prend la deuxième position.

L' élément d'interruption peut être un premier élément de blocage apte à bloquer le dispositif d'interruption 2" dans une position ouverte lorsque le module fonctionnel additionnel 5 est reçu dans la deuxième zone de réception 9'. Dans ce cas, le premier élément de blocage peut être une tige agissant sur le dispositif d'interruption 2".

Ledit module fonctionnel primaire 2 peut comprendre au moins une première borne de connexion 3' reliée au premier pôle de connexion 3 et une deuxième borne de connexion 4' reliée au deuxième pôle de connexion 4, la première borne de connexion 3' et la deuxième borne de connexion 4' pouvant former une première prise.

Selon une possibilité alternative, ledit module fonctionnel primaire 2 peut comprendre au moins un premier fil conducteur relié au premier pôle de connexion 3 et un deuxième fil conducteur relié au deuxième pôle de connexion 4, le premier fil conducteur et le deuxième fil conducteur pouvant être reliés à un bornier du module fonctionnel additionnel 5.

Ledit appareillage électrique 1' peut comprendre en outre un organe de commande 2' apte à agir sur le dispositif d'interruption 2" pour permettre un passage de la position d'ouverture du dispositif d'interruption 2" à la position de fermeture du dispositif d'interruption 2" et/ou pour permettre un passage de la position de fermeture du dispositif d'interruption 2" à la position d'ouverture du dispositif d'interruption 2".

Ledit appareillage électrique 1' peut comprendre un premier boîtier 15 avec lequel la première prise 13 et/ou l'organe de commande 2' sont montés.

Ledit module de réception 8 peut comprendre un cadre support 8' comprenant une ouverture centrale 17 formant au moins en partie lesdites première et deuxième zones de réception 9, 9' recevant le premier boîtier 15 et étant apte à recevoir un deuxième boîtier 16 du module fonctionnel additionnel 5, le premier boîtier 15 pouvant comprendre des moyens de fixation 18, 19 amovibles coopérant avec le cadre support 8'.

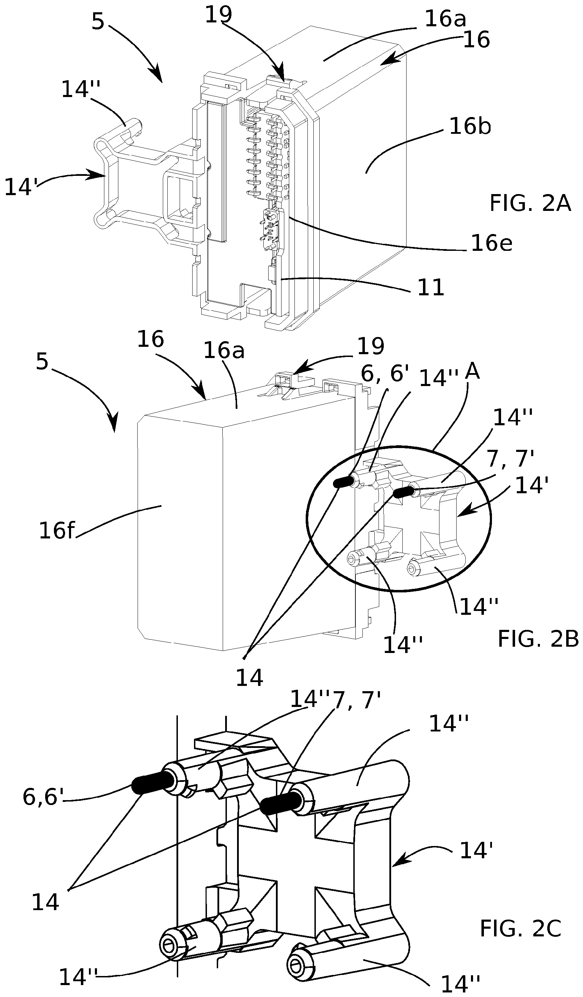

Ledit module fonctionnel additionnel 5 comprend les moyens pour effectuer au moins une fonction nécessitant une alimentation électrique peut être apte à être reçu dans la deuxième zone de réception 9' de l'appareillage électrique 1', le module fonctionnel additionnel 5 pouvant comprendre au moins un quatrième pôle de connexion 6 et un cinquième pôle de connexion 7 apte à être reliés électriquement respectivement au premier pôle de connexion 3 et au deuxième pôle de connexion 4 du module fonctionnel primaire 2 de l'appareillage électrique 1' pour alimenter le module fonctionnel additionnel 5, module fonctionnel additionnel 5 dans lequel soit le module fonctionnel additionnel 5 comprend un élément d'interruption apte à agir sur le dispositif d'interruption 2" de sorte à interrompre le flux du courant entre le premier pôle de connexion 3 et le deuxième pôle de connexion 4 lorsque le module fonctionnel additionnel 5 est reçu dans la deuxième zone de réception 9' de l'appareillage électrique 1', soit le module fonctionnel additionnel 5 est apte à agir sur un élément d'interruption de l'appareillage électrique 1' agissant sur le dispositif d'interruption 2" de sorte à interrompre le flux du courant entre le premier pôle de connexion 3 et le deuxième pôle de connexion 4 lorsque le module fonctionnel additionnel 5 est reçu dans la deuxième zone de réception 9' de l'appareillage électrique 1' (figures 2A à 2E et 3B).

L'élément d'interruption peut donc soit être présent sur l'appareillage 1' ou sur le module fonctionnel additionnel 5. Dans ces deux cas, l'élément d'interruption est agencé pour être apte à agir sur le dispositif d'interruption 2" de sorte à interrompre le flux du courant entre le premier pôle de connexion 3 et le deuxième pôle de connexion 4 lorsque le module fonctionnel additionnel 5 est reçu dans la deuxième zone de réception 9'.

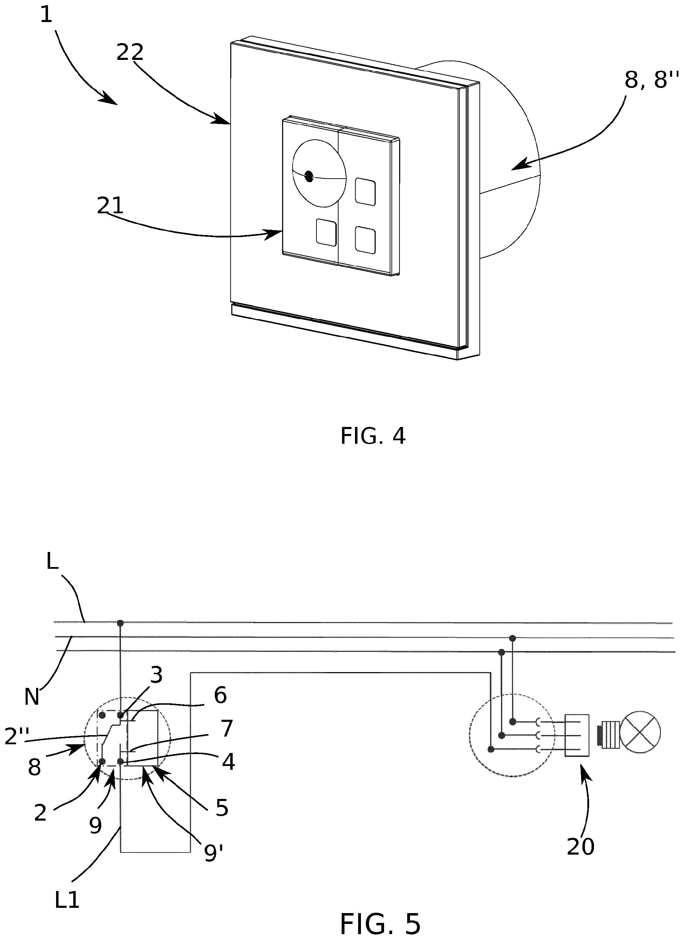

Ledit assemblage électrique 1 (figure 5) comprend un appareillage électrique 1 selon l'invention et un module fonctionnel additionnel 5 comprenant des moyens pour effectuer au moins une fonction nécessitant une alimentation électrique selon l'invention, ledit module fonctionnel additionnel 5 étant reçu dans la deuxième zone de réception 9' de l'appareillage électrique 1', le quatrième pôle de connexion 6 et le cinquième pôle de connexion 7 du module fonctionnel additionnel étant reliés électriquement respectivement au premier pôle de connexion 3 et au deuxième pôle de connexion 4 du module fonctionnel primaire 2 de l'appareillage électrique 1' pour alimenter le module fonctionnel additionnel 5, l'élément d'interruption agissant sur le dispositif d'interruption 2" de sorte à interrompre le flux du courant entre le premier pôle de connexion 3 et le deuxième pôle de connexion 4.

L' élément d'interruption peut être un premier élément de blocage apte à bloquer le dispositif d'interruption 2" dans une position ouverte lorsque le module fonctionnel additionnel 5 est reçu dans la deuxième zone de réception 9'. Dans ce cas, le premier élément de blocage peut être une tige agissant sur le dispositif d'interruption 2".

Ladite au moins une fonction du module fonctionnel additionnel 5 peut être une fonction nécessitant une alimentation électrique à l'exclusion d'une fonction d'éclairage de voyant lumineux liée à la position d'ouverture et/ou la position de fermeture de l'organe de commande 2' du module fonctionnel primaire 2.

On entend par fonction d'éclairage de voyant lumineux exclue, une fonction d'éclairage de voyant lumineux qui est généralement mise en œuvre au moyen d'un voyant lumineux apte et destiné à être allumé lorsque le dispositif d'interruption 2" est en position d'ouverture et à être éteint lorsque le dispositif d'interruption 2" est en position de fermeture. Par exemple, lorsque le module fonctionnel primaire 2 commande une charge 20, tel qu'un éclairage, le voyant lumineux est allumé lorsque l'éclairage n'est pas alimenté et est donc éteint et le voyant lumineux est éteint lorsque l'éclairage est alimenté et est donc allumé. Ce type de voyant lumineux est le plus souvent employé pour localiser et repérer l'appareillage électrique 1' dans l'obscurité d'une partie d'un bâtiment (non représenté), telle qu'une cage d'escalier (non représentée).

Avantageusement, l'assemblage électrique 1 permet de réaliser au moins une fonction au-delà de la fonction d'interruption à l'aide du module fonctionnel additionnel 5. Ainsi, le module fonctionnel additionnel 5 permet une personnalisation de l'appareillage électrique 1'. En outre, le module fonctionnel additionnel 5 étant optionnel, il peut être installé ou retiré à tout moment sans impacter l'installation électrique. En effet, l'appareillage électrique 1' est apte à fonctionner en tant que tel, sans qu'un module fonctionnel additionnel 5 soit reçu dans la deuxième zone de réception 9' de l'appareillage électrique 1'. L'appareillage électrique 1' obtenu est ainsi particulièrement modulable et peut être transformé aisément en un assemblage électrique 1 capable d'effectuer des fonctions plus sophistiquées grâce au module fonctionnel additionnel 5. Par ailleurs, la fonction supplémentaire du module fonctionnel additionnel 5 n'est pas destinée à informer l'utilisateur sur la localisation ou l'état de la fonction d'interruption, mais s'étend avantageusement à des fonctions indépendantes de la fonction d'interruption.

Selon une possibilité, l'appareillage électrique 1' peut en outre comprendre un organe de commande 2' apte à agir sur le dispositif d'interruption 2" pour permettre un passage de la position d'ouverture du dispositif d'interruption 2" à la position de fermeture du dispositif d'interruption 2" et/ou pour permettre un passage de la position de fermeture du dispositif d'interruption 2" à la position d'ouverture du dispositif d'interruption 2".

L'appareillage électrique 1' et/ou l'assemblage électrique 1 est/sont préférentiellement destiné(s) à être monté(s) avec ou encastré(s) dans un support (non représenté), tel qu'un mur.

Le dispositif d'interruption 2" du courant du module fonctionnel primaire 2 peut être un interrupteur monostable ou un interrupteur bistable.

Dans le cas d'un interrupteur monostable, en position d'ouverture de l'organe de commande 2', de l'organe de commande 2' peut être agencé pour ne pas agir sur le dispositif d'interruption 2", qui lui aussi reste en position d'ouverture, et en position de fermeture de l'organe de commande 2', l'organe de commande 2' peut être agencé pour faire passer le dispositif d'interruption 2" à la position de fermeture. Selon cette configuration le module interrupteur monostable est également appelé « normalement ouvert ». Selon une alternative de module interrupteur monostable, en position d'ouverture de l'organe de commande 2', l'organe de commande 2' peut être agencé pour faire passer le dispositif d'interruption 2" en position de fermeture et en position de fermeture de l'organe de commande 2', l'organe de commande 2' n'agit pas sur la fermeture du dispositif d'interruption 2". Selon cette configuration le module interrupteur monostable est également appelé « normalement fermé ». L'organe de commande 2' d'un module interrupteur monostable peut être préférentiellement un bouton poussoir (non représenté).

Pour un module interrupteur bistable, en position d'ouverture de l'organe de commande 2', l'organe de commande 2' peut être agencé pour faire passer le dispositif d'interruption 2" en position de ouverture et en position de fermeture de l'organe de commande 2', l'organe de commande 2' peut être agencé pour faire passer le dispositif d'interruption 2" en position de fermeture. Dans ce cas, l'organe de commande 2' peut préférentiellement être un bouton à bascule pouvant adopter deux positions Cet exemple n'est toutefois pas limitatif.

Le module fonctionnel additionnel 5 peut comprendre en outre un deuxième élément de blocage apte à bloquer l'organe de commande 2' dans la position ouverte lorsque le module fonctionnel additionnel 5 est reçu dans la deuxième zone de réception 9' de l'appareillage électrique 1'.

Le module fonctionnel primaire 2 peut comprendre un premier pôle de connexion 3 apte et destiné à être relié à une première ligne L du réseau électrique et un deuxième pôle de connexion 4 apte et destiné à être relié à une deuxième ligne L1 d'un circuit électrique de l'installation électrique.

La première ligne L peut être une ligne d'alimentation reliée au réseau électrique préférentiellement par l'intermédiaire d'un appareil de coupure, tel qu'un disjoncteur.

La deuxième ligne L1 peut être un retour du circuit électrique de l'installation électrique pour alimenter une charge 20 de l'installation électrique, telle qu'un éclairage.

La première ligne L et la deuxième ligne L1 peuvent se matérialiser par un ou des câbles (non représentés).

L'installation électrique peut préférentiellement être une installation électrique domestique.

Selon une possibilité, ladite au moins une fonction du module fonctionnel additionnel 5 est une fonction de mise en forme des paramètres physiques d'un signal électrique en provenance de la première ligne (L) du réseau électrique.

Le module fonctionnel additionnel 5 peut comprendre au moins des moyens de traitement du signal électrique aptes et destinés à effectuer ladite fonction de mise en forme des paramètres physiques du signal électrique.

Les moyens de traitement peuvent être aptes et destinés à modifier la forme du signal électrique, à faire varier la tension du signal électrique et/ou de l'intensité du courant du signal électrique, à faire varier la puissance du signal électrique, à faire varier la fréquence du signal électrique.

Les moyens de traitement peuvent être aptes et destinés à être actionnés localement ou à distance par des moyens de commande.

Les moyens de traitement peuvent être choisis parmi: un variateur, un relais, un filtre, un commutateur, un transistor semiconducteur, préférentiellement du type MOSFET.

Les moyens de commande peuvent, dans ce cas, consister en une unité de contrôle, de type smartphone ou télécommande, distante de l'appareillage électrique 1 et ne faisant pas partie de l'installation électrique. Par exemple, une liaison sans fil, via des moyens d'émission et/ou de réception d'ondes électromagnétique décrits ci-après, peut permettre d'établir une communication entre l'unité de contrôle et les moyens de traitement. Selon une variante alternative, les moyens de traitement peuvent être actionnées via un bouton de commande, distant de l'appareillage électrique 1, et faisant partie de l'installation électrique. Dans ce cas, la liaison entre le bouton de commande et les moyens de traitement peut être filaire ou sans fil.

Ladite au moins une fonction du module fonctionnel additionnel 5 peut être choisie seule ou en combinaison parmi une fonction de mesure d'au moins un paramètre physique et/ou une fonction d'émission et/ou de réception de rayonnements électromagnétiques, et/ou une fonction d'affichage, et/ou une fonction d'actionnement, et/ou une fonction de traitement de données, et/ou une fonction de transformation d'un signal physique en un signal électrique ou inversement.

Ledit au moins un paramètre physique peut être la température, la pression, l'hygrométrie, l'intensité lumineuse, bien entendu ces exemples ne sont pas limitatifs.

La fonction d'émission et/ou de réception de rayonnements électromagnétiques peut être limitée aux rayonnements électromagnétiques radiofréquences. Cette configuration est notamment préférée pour permettre la communication de données de l'assemblage électrique 1 vers une unité de contrôle (non représentée) décrite ci-après.

La fonction du module fonctionnel additionnel 5 peut être apte et destinée à être alimentée et activée lorsque le dispositif d'interruption 2" du module fonctionnel primaire 2 est en position d'ouverture.

Avantageusement, le module fonctionnel additionnel 5 étant branché en parallèle par rapport au circuit électrique entre le premier pôle de connexion 3 et le deuxième pôle de connexion 4 du module fonctionnel primaire 2, les moyens pour effectuer la fonction du module fonctionnel additionnel 5 sont aptes à être alimentés par le réseau électrique lorsque le dispositif d'interruption 2" du module fonctionnel primaire 2 est en position d'ouverture, c'est-à-dire lorsque l'élément d'interruption agit sur le dispositif d'interruption 2" de sorte à interrompre le flux du courant entre le premier pôle de connexion 3 et le deuxième pôle de connexion 4, par exemple en maintenant le dispositif d'interruption 2" en position ouverte, quand le module fonctionnel additionnel est reçu dans la deuxième zone de réception 9'. Il en résulte que lorsque le dispositif d'interruption 2" est en position d'ouverture, par exemple lorsque le module fonctionnel additionnel est reçu dans la deuxième zone de réception 9', la fonction du module fonctionnel additionnel 5 peut être activée. Lorsque le dispositif d'interruption 2" est en position de fermeture les moyens pour effectuer la fonction du module fonctionnel additionnel 5 sont court-circuités et donc n'est pas alimentés et est désactivés.

Le module fonctionnel additionnel 5 peut comprendre un élément de stockage et/ou de production d'énergie électrique et la fonction du module fonctionnel additionnel 5 peut être apte et destinée à être alimentée par ledit élément de stockage et/ou de production d'énergie électrique.

Avantageusement, la fonction du module fonctionnel additionnel 5 est apte à être alimentée par un élément de stockage et/ou de production d'énergie électrique qui peut être rendu indépendant et autonome relativement au réseau électrique. Il en résulte que la fonction du module fonctionnel additionnel 5 peut être activée indépendamment de la position d'ouverture ou de fermeture du module fonctionnel primaire 2. Par exemple, lorsque l'organe de commande 2' est en position de fermeture la fonction du module fonctionnel additionnel 5 n'est plus court-circuitée et peut donc être alimentée par l'élément de stockage et/ou de production d'énergie électrique et être activée.

L'élément de stockage et/ou de production d'énergie électrique peut être une batterie, un condensateur, un générateur piézoélectrique, un générateur photovoltaïque, un générateur thermoélectrique, par exemple du type Peltier ou Seebeck.

Le module fonctionnel additionnel 5 peut comprendre au moins un capteur de mesure apte et destiné à effectuer ladite fonction de mesure d'au moins un paramètre physique.

Le capteur de mesure peut être un capteur de température, un capteur de pression, un hygromètre, un photodétecteur, un capteur infrarouge, un transducteur, bien entendu ces exemples ne sont pas limitatifs.

Le module fonctionnel additionnel 5 peut comprendre au moins des moyens d'émission et/ou de réception d'ondes électromagnétiques aptes et destinés à effectuer ladite fonction d'émission et/ou de réception de rayonnements électromagnétiques.

Ces moyens d'émission et/ou de réception d'ondes électromagnétiques peuvent être un élément de communication radiofréquence, par exemples, Wi-Fi ou Bluetooth, un répéteur. Bien entendu ces exemples ne sont pas limitatifs.

Avantageusement, ces moyens d'émission et/ou de réception d'ondes électromagnétiques permettent la réception et/ou l'émission de données pouvant notamment être relatives au module fonctionnel additionnel 5. De tels moyens d'émission et/ou de réception d'ondes électromagnétiques peuvent en outre établir un lien de communication sans fil avec une unité de contrôle, comme un ordinateur, un smartphone ou une tablette numérique ou vers un autre module fonctionnel additionnel 5 selon l'invention et qui serait également muni de moyens d'émission et/ou de réception d'ondes électromagnétiques. Il est ainsi possible d'interagir à distance avec l'assemblage électrique 1.

Le module fonctionnel additionnel 5 peut comprendre au moins des moyens d'affichage aptes et destinés à effectuer ladite fonction d'affichage.

Avantageusement, ces moyens d'affichage permettent de former une interface visuelle avec un utilisateur.

Ces moyens d'affichage peuvent être un écran.

Le module fonctionnel additionnel 5 peut comprendre au moins des moyens d'actionnement aptes et destinés à effectuer ladite fonction d'actionnement.

Les moyens d'actionnement peuvent être un actionneur, par exemples, un relais, un solénoïde, un micromoteur, un mécanisme piézoélectrique ou de manière générale, tout type de moyens configurés pour transformer une grandeur électrique en une grandeur mécanique ou inversement.

Le module fonctionnel additionnel 5 peut comprendre au moins des moyens de traitement de données aptes et destinés à effectuer ladite fonction de traitement de données.

Les moyens de traitement de données peuvent être un microcontrôleur. Ces moyens de traitement de données peuvent, par exemple, permettre de traiter des données issues du capteur de mesure.

Le module fonctionnel additionnel 5 peut comprendre au moins des moyens de prise de vues, par exemple, une caméra.

Le module fonctionnel additionnel 5 peut comprendre au moins un transducteur apte et destiné à effectuer ladite fonction de transformation d'un signal physique en un signal électrique ou inversement.

Le transducteur peut être un transducteur électroacoustique, tel qu'un haut-parleur ou un microphone.

Le transducteur peut être un vibreur ou un diffuseur.

Le module fonctionnel additionnel 5 peut comprendre au moins une carte électronique 10, 11, comprenant le capteur de mesure, et/ou les moyens d'émission et/ou de réception d'ondes électromagnétiques, et/ou les moyens d'affichage, et/ou les moyens d'actionnement, et/ou les moyens de traitement de données, et/ou les moyens de prise de vues et/ ou le transducteur.

Selon une variante de réalisation de l'invention, une première carte électronique 10 peut comprendre le capteur de mesure, et/ou les moyens d'affichage, et/ou les moyens d'actionnement et/ou de réception d'ondes électromagnétiques, et/ou un transducteur et/ou des moyens de prise de vues et une deuxième carte électronique 11 peut comprendre les moyens d'émission et/ou de réception d'ondes électromagnétiques et/ou les moyens de traitement de données et une troisième carte électronique (non représentée) peut comprendre l'élément de stockage et/ou de production d'énergie électrique.

La première carte électronique 10, la deuxième carte électronique 11 et la troisième carte électronique peuvent être reliées électriquement entre elles.

Préférentiellement, la première carte électronique 10 peut être une pièce amovible du module fonctionnel additionnel 5.

Avantageusement, la ou les fonctions du module fonctionnel additionnel 5 peuvent ainsi être modifiées simplement et aisément en remplaçant la première carte électronique 10. Il n'est ainsi pas nécessaire de remplacer l'ensemble du module fonctionnel additionnel 5.

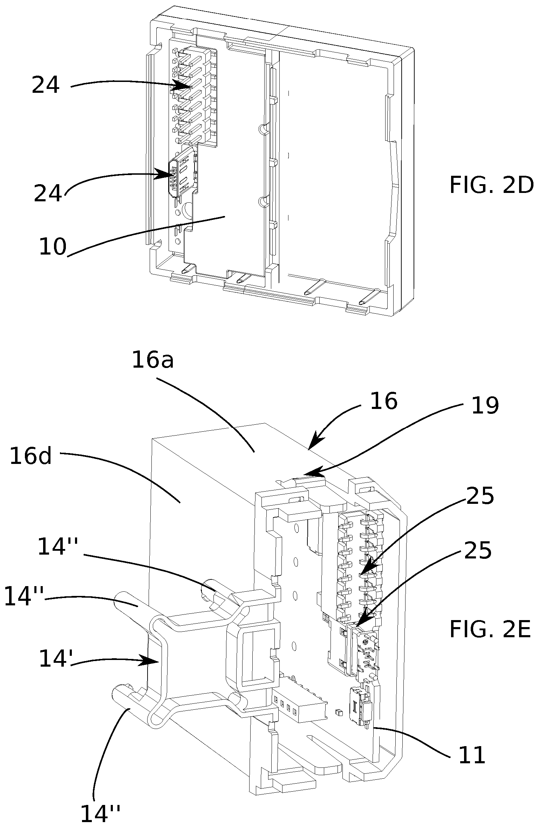

En particulier, la première carte électronique 10 peut comprendre au moins des premiers moyens de connexion 24 complémentaires d'au moins des deuxièmes moyens de connexion 25 de la deuxième carte électronique 11. Ces derniers permettent de relier électriquement et mécaniquement la première carte électronique 10 et la deuxième carte électronique 11 de manière amovible et réversible (figures 2A et 2D).

Les premiers moyens de connexion 24 et les deuxièmes moyens de connexion 25 peuvent consister en une connexion USB, à titre d'exemple non limitatif.

Le module fonctionnel primaire 2 peut comprendre au moins une première borne de connexion 3' reliée électriquement au premier pôle de connexion 3 et une deuxième borne de connexion 4' reliée électriquement au deuxième pôle de connexion 4 et la première borne de connexion 3' et la deuxième borne de connexion 4' peuvent former une première prise 13 (figure 1C). Selon une possibilité alternative, ledit module fonctionnel primaire 2 peut comprendre au moins un premier fil conducteur relié au premier pôle de connexion 3 et un deuxième fil conducteur relié au deuxième pôle de connexion 4, le premier fil conducteur et le deuxième fil conducteur pouvant être reliés à un bornier du module fonctionnel additionnel 5.

Le module fonctionnel additionnel 5 peut comprendre au moins une quatrième borne de connexion 6' reliée électriquement au quatrième pôle de connexion 6 et une cinquième borne de connexion 7' reliée électriquement au cinquième pôle de connexion 7 et la quatrième borne de connexion 6' et la cinquième borne de connexion 7' peuvent former une deuxième prise 14 (figures 2B et 2C). Selon une possibilité alternative, ledit module fonctionnel additionnel 5 peut comprendre un bornier reliée électriquement au quatrième pôle de connexion 6 et au cinquième pôle de connexion 7. Le premier fil conducteur et le deuxième fil conducteur du module fonctionnel primaire 2 peuvent être reliés au bornier.

La première prise 13 du module fonctionnel primaire 2 et la deuxième prise 14 du module fonctionnel additionnel 5 peuvent présenter des formes complémentaires pour être connectées et pour relier électriquement et mécaniquement la première borne de connexion 3' à la quatrième borne de connexion 6' et pour relier électriquement et mécaniquement la deuxième borne de connexion 4' à la cinquième borne de connexion 7' (figures 1C, 2B, 2C, 3B, 5).

La première borne de connexion 3' et la deuxième borne de connexion 4' peuvent être respectivement une première borne femelle et une deuxième borne femelle, par exemple se présentant sous la forme de cavité munie de contact électrique. Dans ce cas, la première prise 13 est une prise femelle. Préférentiellement, cette première prise 13 peut comprendre deux cavités réparties le long d'un côté d'un carré (figure 1C).

Préférentiellement, la première prise 13 de type prise femelle peut présenter un indice de protection dont le degré de protection contre les solides est compris entre 0 et 6 et dont le degré de protection contre les liquides est compris entre 0 et 8. Par exemple, l'indice de protection peut être égal à IP2X, X étant une valeur comprise entre 0 et 8.

La quatrième borne de connexion 6' et la cinquième borne de connexion 7' peuvent être respectivement une quatrième borne mâle et une cinquième borne mâle, par exemple se présentant sous la forme de tige. Dans ce cas, la deuxième prise 14 est une prise mâle. La deuxième prise 14 peut comprendre une embase 14' de laquelle s'étend la quatrième borne de connexion 6' et la cinquième borne de connexion 7' sous la forme de tige. Préférentiellement, l'embase 14' présente une forme sensiblement carrée avec des coins arrondis desquels s'étendent quatre plots 14" s'étendant sensiblement orthogonalement à l'embase 14'. Ces plots 14" forment un emboîtement mécanique avec la première prise 13 de type prise femelle, ces plots 14" pouvant s'emboîter dans les cavités. Deux de ces plots 14" peuvent supporter les deux tiges formant la quatrième borne de connexion 6' et la cinquième borne de connexion 7' (figures 2A, 2B, 2C, 2E).

Le module fonctionnel primaire 2 peut comprendre un premier boîtier 15 avec lequel la première prise 13 et l'organe de commande 2' sont montés (figures 1A, 1B et 1C).

Le premier boîtier 15 permet de protéger le module fonctionnel primaire 2.

Le premier boîtier 15 peut être en matériau polymère.

Le premier boîtier 15 peut comprendre quatre faces latérales 15a, 15b, 15d, une ouverture avant 15e, et une face arrière 15f. Le premier boîtier 15 peut présenter une section sensiblement rectangulaire.

Préférentiellement, la première prise 13 et l'organe de commande 2' recouvrent l'ouverture avant 15e. Il en résulte avantageusement que la première prise est accessible par l'avant du module fonctionnel primaire 2, ce qui facilite l'emboîtement avec la deuxième prise 14 du module fonctionnel additionnel 5.

Le module fonctionnel additionnel 5 peut comprendre un deuxième boîtier 16 dans lequel est logée ladite au moins une carte électronique 10, 11, 12 comprenant le capteur de mesure, et/ou les moyens d'émission et/ou de réception d'ondes électromagnétiques, et/ou les moyens d'affichage, et/ou les moyens d'actionnement, et/ou les moyens de traitement de données et/ou le transducteur.

Le deuxième boîtier 16 permet de protéger le module fonctionnel additionnel 5 (figures 2A et 2B).

La deuxième prise 14 du module fonctionnel additionnel 5 peut faire saillie du deuxième boîtier 16 du module fonctionnel additionnel 5.

Le deuxième boîtier 16 peut être en matériau polymère.

Le deuxième boîtier 16 peut comprendre quatre faces latérales 16a, 16b, 16c, 16d, une ouverture avant 16e, et une face arrière 16f. Le deuxième boîtier 16 peut présenter une section sensiblement rectangulaire.

Préférentiellement, l'embase 14' de la deuxième prise 14 peut s'étendre dans le plan de l'ouverture avant 16e et les plots 14" peuvent s'étendre dans la direction des faces latérales 16a, 16b, 16d.

Le deuxième boîtier 16, l'embase 14' et les plots 14" peuvent former une unique pièce monobloc, venue par exemple de moulage.

De manière alternative, la deuxième prise 14 peut être un élément amovible (non représenté) du deuxième boîtier 16. Plus particulièrement, l'embase 14' peut être reliée mécaniquement au deuxième boîtier 16 de manière amovible et réversible par des moyens de connexion mécanique (non représentés). En outre, l'embase 14' peut comprendre des moyens de connexion électrique (non représentés) reliés électriquement à la quatrième borne de connexion 6' et à la cinquième borne de connexion 7' et complémentaires de moyens de connexion électrique (non représentés) disposés au niveau du deuxième boîtier 16. Ces moyens de connexion électrique du deuxième boîtier 16 peuvent consister en un bornier.

Une des faces latérales 15b du premier boîtier 15a peut être adjacente à une des faces latérales 16d du deuxième boîtier 16, plus particulièrement ces faces latérales 15b, 16d peuvent être accolées et en regard l'une de l'autre. Ces faces latérales 15b, 16d accolées peuvent comprendre des moyens de guidage (non représentés) pour faciliter le positionnement des premier et deuxième boîtiers 15, 16 l'un par rapport à l'autre.

La première carte électronique 10 peut recouvrir l'ouverture avant 16e.

Avantageusement, du fait de cette configuration la première carte électronique 10 est facilement accessible et peut aisément être solidarisée/désolidarisée de la deuxième carte électronique 11 pour être remplacée.

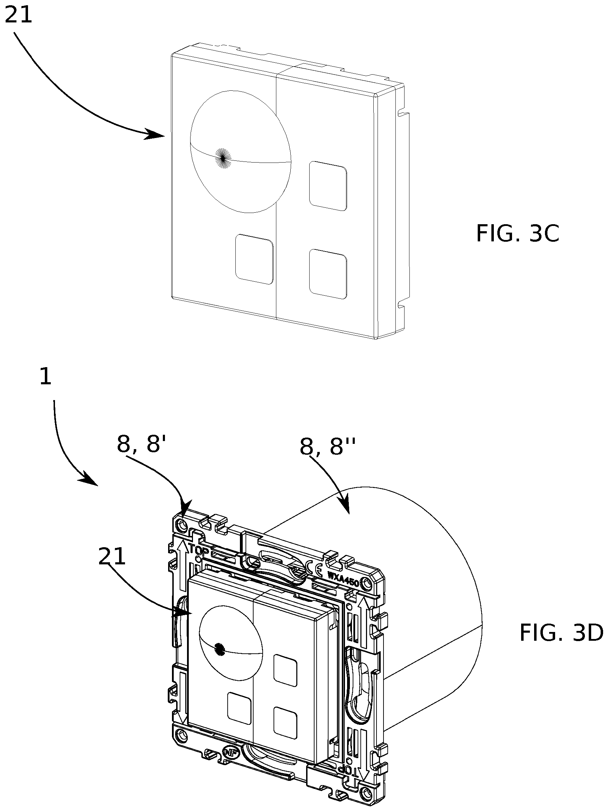

Le module de réception 8 peut comprendre un cadre support 8' comprenant une ouverture centrale 17 formant au moins en partie lesdites première et deuxième zones de réception 9, 9' recevant le premier boîtier 15 (figures 3A, 3B, 3D) et le deuxième boîtier 16 et le premier boîtier 15 et le deuxième boîtier 16 peuvent comprendre respectivement des moyens de fixation 18, 19 amovibles coopérant avec le cadre support 8' (figures 1A, 1B, 2A, 2B).

Préférentiellement, les moyens de fixation 18, 19 respectivement du premier boîtier 15 et du deuxième boîtier 16 peuvent consister en deux pattes saillantes respectivement de deux des faces latérales opposées 15a, 15c ; 16a ,16c (figures 1A, 1B, 1C, 2A, 2B, et 2D).

Le module de réception 8 peut également comprendre un boîtier d'encastrement 8" sur lequel peut être fixé le cadre support 8' par des moyens de fixation (non représentés). Ce boîtier d'encastrement 8" peut être destiné à être encastré dans un support, tel qu'un mur.

Le boîtier d'encastrement 8' peut comprendre un logement pour recevoir les quatre faces latérales 15a, 15b, 15d et la face arrière 15f du premier boîtier 15 et les quatre faces latérales 16a, 16b, 16d et la face arrière 16f du deuxième boîtier 16.

L'organe de commande 2', l'embase 14' de la deuxième prise 14 et la première carte électronique 10 peuvent être recouverts d'au moins une plaque de recouvrement 21 comprenant au moins un bouton (non représenté) ou non qui permet d'actionner l'organe de commande 2' du module fonctionnel primaire 2 (figures 3C, 3D, 4).

La plaque de recouvrement 21 joue à la fois le rôle d'interface avec l'utilisateur et peut également présenter une fonction esthétique et une fonction de protection.

La plaque de recouvrement 21 peut également permettre de condamner l'organe de commande 2' qui ne peut, dans ce cas, plus être actionné. Dans ce cas, la plaque de recouvrement 21 peut comprendre le deuxième élément de blocage apte à bloquer l'organe de commande 2' .

Le cadre support 8' peut être recouvert d'un cadre de recouvrement 22.

La carte électronique 10 pour module fonctionnel additionnel 5 tel que décrit précédemment peut être prévue.

La carte électronique 10 comprend un capteur de mesure, et/ou des moyens d'affichage, et/ou des moyens d'actionnement et elle comprend au moins des premiers moyens de connexion 24 pour être apte et destinée à former une pièce amovible dudit module fonctionnel additionnel 5.

Cette carte électronique correspond à la première carte électronique 10 telle que décrite précédemment.

Bien entendu, l'invention n'est pas limitée aux modes de réalisation décrits et représentés aux dessins annexés. Des modifications restent possibles, notamment du point de vue de la constitution des divers éléments ou par substitution d'équivalents techniques, sans sortir pour autant du domaine de protection de l'invention.

## Revendications

1. Appareillage électrique (1') pour une installation électrique apte et destiné à être relié à un réseau électrique, comprenant au moins :
- un module de réception (8) comprenant au moins une première zone de réception (9) ;
- un module fonctionnel primaire (2) reçu dans la première zone de réception (9) et comprenant un premier pôle de connexion (3) apte et destiné à être relié à une première ligne (L) du réseau électrique et un deuxième pôle de connexion (4) apte et destiné à être relié à une deuxième ligne (L1) d'un circuit électrique de l'installation électrique,
le module fonctionnel primaire (2) comprenant un dispositif d'interruption du courant (2") agencé entre le premier pôle de connexion (3) et le deuxième pôle de connexion (4) et apte, dans une position d'ouverture, à interrompre le courant entre le premier pôle de connexion (3) et le deuxième pôle de connexion (4) et, dans une position de fermeture, à permettre le passage du courant entre le premier pôle de connexion (3) et le deuxième pôle de connexion (4),
appareillage électrique (1') **caractérisé en ce que** le module de réception comprend une deuxième zone de réception (9') pour recevoir un module fonctionnel additionnel (5) selon la revendication 8, ledit module fonctionnel additionnel (5) comportant des moyens pour effectuer au moins une fonction nécessitant une alimentation électrique, au moins un quatrième pôle de connexion (6) et un cinquième pôle de connexion (7) aptes à être reliés électriquement respectivement au premier pôle de connexion (3) et au deuxième pôle de connexion (4) du module fonctionnel primaire (2) pour alimenter le module fonctionnel additionnel (5), et **en ce que** soit l'appareillage électrique (1') comprend un élément d'interruption étant apte à agir sur le dispositif d'interruption (2") de sorte à interrompre le flux du courant entre le premier pôle de connexion (3) et le deuxième pôle de connexion (4) lorsque le module fonctionnel additionnel (5) est reçu dans la deuxième zone de réception (9'), soit un élément d'interruption du module fonctionnel additionnel (5) est apte à agir sur le dispositif d'interruption (2") de sorte à interrompre le flux du courant entre le premier pôle de connexion (3) et le deuxième pôle de connexion (4) lorsque le module fonctionnel additionnel (5) est reçu dans la deuxième zone de réception (9').

2. Appareillage électrique selon la revendication 1, **caractérisé en ce que** le dispositif d'interruption (2") comprend en outre un shunt (28) apte à établir le flux du courant entre le premier pôle de connexion (3) et le deuxième pôle de connexion (4) dans une première position et apte à être déplacé depuis la première position vers une deuxième position par l'élément d'interruption lorsque le module fonctionnel additionnel (5) est reçu dans la deuxième zone de réception (9') de sorte à interrompre le flux du courant entre le premier pôle de connexion (3) et le deuxième pôle de connexion (4).

3. Appareillage électrique selon la revendication 1, **caractérisé en ce que** l'élément d'interruption est un premier élément de blocage apte à bloquer le dispositif d'interruption (2") dans une position ouverte lorsque le module fonctionnel additionnel (5) est reçu dans la deuxième zone de réception (9').

4. Appareillage électrique selon l'une quelconque des revendications 1 à 3, **caractérisé en ce que** le module fonctionnel primaire (2) comprend au moins une première borne de connexion (3') reliée électriquement au premier pôle de connexion (3) et une deuxième borne de connexion (4') reliée électriquement au deuxième pôle de connexion (4) et **en ce que** la première borne de connexion (3') et la deuxième borne de connexion (4') forment une première prise (13).

5. Appareillage électrique selon l'une quelconque des revendications 1 à 4, **caractérisé en ce qu'**il comprend en outre un organe de commande (2') apte à agir sur le dispositif d'interruption (2") pour permettre un passage de la position d'ouverture du dispositif d'interruption (2") à la position de fermeture du dispositif d'interruption (2") et/ou pour permettre un passage de la position de fermeture du dispositif d'interruption (2") à la position d'ouverture du dispositif d'interruption (2").

6. Appareillage électrique selon l'une quelconque des revendications 4 ou 5, **caractérisé en ce qu'**il comprend un premier boîtier (15) avec lequel la première prise (13) et/ou l'organe de commande (2') sont montés.

7. Appareillage électrique selon la revendication 6, **caractérisé en ce que** le module de réception (8) comprend un cadre support (8') comprenant une ouverture centrale (17) formant au moins en partie lesdites première et deuxième zones de réception (9, 9') recevant le premier boîtier (15) et étant apte à recevoir un deuxième boîtier (16) du module fonctionnel additionnel (5) et **en ce que** le premier boîtier (15) comprend des moyens de fixation (18, 19) amovibles coopérant avec le cadre support.

8. Module fonctionnel additionnel (5) pour ledit appareillage électrique (1') selon l'une quelconque des revendications 1 à 7, le module fonctionnel additionnel (5) comportant les moyens pour effectuer au moins la fonction nécessitant une alimentation électrique, **caractérisé en ce qu'**il apte à être reçu dans la deuxième zone de réception (9') de l'appareillage électrique (1'), le module fonctionnel additionnel (5) comprenant au moins le quatrième pôle de connexion (6) et le cinquième pôle de connexion (7) apte à être reliés électriquement respectivement au premier pôle de connexion (3) et au deuxième pôle de connexion (4) du module fonctionnel primaire (2) de l'appareillage électrique (1') pour alimenter le module fonctionnel additionnel (5), et **en ce que** soit ledit élément d'interruption du module fonctionnel additionnel (5) est apte à agir sur le dispositif d'interruption (2") de sorte à interrompre le flux du courant entre le premier pôle de connexion (3) et le deuxième pôle de connexion (4) lorsque le module fonctionnel additionnel (5) est reçu dans la deuxième zone de réception (9') de l'appareillage électrique (1'), soit le module fonctionnel additionnel (5) est apte à agir sur ledit élément d'interruption de l'appareillage électrique (1') agissant sur le dispositif d'interruption (2") de sorte à interrompre le flux du courant entre le premier pôle de connexion (3) et le deuxième pôle de connexion (4) lorsque le module fonctionnel additionnel (5) est reçu dans la deuxième zone de réception (9') de l'appareillage électrique (1').

9. Module fonctionnel additionnel selon la revendication 8, **caractérisé en ce que** l'élément d'interruption est un premier élément de blocage apte à bloquer le dispositif d'interruption (2") dans une position ouverte lorsque le module fonctionnel additionnel (5) est reçu dans la deuxième zone de réception (9').

10. Module fonctionnel additionnel selon l'une quelconque des revendications 8 ou 9, **caractérisé en ce que** ladite au moins une fonction du module fonctionnel additionnel (5) est une fonction nécessitant une alimentation électrique à l'exclusion d'une fonction d'éclairage de voyant lumineux liée à la position d'ouverture et/ou la position de fermeture du dispositif d'interruption (2") du module fonctionnel primaire (2).

11. Module fonctionnel additionnel selon l'une quelconque des revendications 8 à 10, **caractérisé en ce qu'**il comprend au moins une quatrième borne de connexion (6') reliée électriquement au quatrième pôle de connexion (6) et une cinquième borne de connexion (7') reliée électriquement au cinquième pôle de connexion (7) et **en ce que** la quatrième borne de connexion (6') et la cinquième borne de connexion (4') forment une deuxième prise (14).

12. Module fonctionnel additionnel selon l'une quelconque des revendications 8 à 11, **caractérisé en ce que** la fonction du module fonctionnel additionnel (5) est apte et destinée à être alimentée et activée lorsque le dispositif d'interruption (2") du module fonctionnel primaire (2) est en position d'ouverture et/ou lorsque le shunt (28) déplacé vers la deuxième position.

13. Module fonctionnel additionnel selon l'une quelconque des revendications 8 à 12, **caractérisé en ce qu'**il comprend en outre un deuxième élément de blocage apte à bloquer l'organe de commande (2') dans la position ouverte lorsque le module fonctionnel additionnel (5) est reçu dans la deuxième zone de réception (9') de l'appareillage électrique (1').

14. Module fonctionnel additionnel selon l'une quelconque des revendications 8 à 13, **caractérisée en ce qu'**il comprend une carte électronique (10, 11) qui comprend un capteur de mesure, et/ou des moyens d'émission et/ou de réception d'ondes électromagnétiques, et/ou des moyens d'affichage, et/ou des moyens d'actionnement, et/ou des moyens de traitement de données.

15. Assemblage électrique (1) comprenant un appareillage électrique (1') selon l'une quelconque des revendications 1 à 7 et un module fonctionnel additionnel (5) selon l'une quelconque des revendications 8 à 14, ledit module fonctionnel additionnel (5) étant reçu dans la deuxième zone de réception (9') de l'appareillage électrique (1'), le quatrième pôle de connexion (6) et le cinquième pôle de connexion (7) du module fonctionnel additionnel étant reliés électriquement respectivement au premier pôle de connexion (3) et au deuxième pôle de connexion (4) du module fonctionnel primaire (2) de l'appareillage électrique (1') pour alimenter le module fonctionnel additionnel (5), l'élément d'interruption agissant sur le dispositif d'interruption (2") de sorte à interrompre le flux du courant entre le premier pôle de connexion (3) et le deuxième pôle de connexion (4).

## Patentansprüche

1. Elektrische Ausrüstung (1') für eine elektrische Anlage, die dazu geeignet und bestimmt ist, mit einem elektrischen Netz verbunden zu werden, umfassend mindestens:
- ein Aufnahmemodul (8), das mindestens einen ersten Aufnahmebereich (9) umfasst;
- ein primäres Funktionsmodul (2), das in dem ersten Aufnahmebereich (9) aufgenommen ist und einen ersten Anschlusspol (3), der dazu geeignet und bestimmt ist, mit einer ersten Leitung (L) des elektrischen Netzes verbunden zu werden, und einen zweiten Anschlusspol (4), der dazu geeignet und bestimmt ist, mit einer zweiten Leitung (L1) eines elektrischen Kreises der elektrischen Anlage verbunden zu werden, umfasst,
wobei das primäre Funktionsmodul (2) eine Vorrichtung zur Unterbrechung des Stroms (2") umfasst, die zwischen dem ersten Anschlusspol (3) und dem zweiten Anschlusspol (4) angeordnet ist und dazu geeignet ist, in einer Öffnungsstellung den Strom zwischen dem ersten Anschlusspol (3) und dem zweiten Anschlusspol (4) zu unterbrechen und in einer Schließstellung den Durchgang des Stroms zwischen dem ersten Anschlusspol (3) und dem zweiten Anschlusspol (4) zu ermöglichen,
wobei die elektrische Ausrüstung (1') **dadurch gekennzeichnet ist, dass** das Aufnahmemodul einen zweiten Aufnahmebereich (9') umfasst, um ein zusätzliches Funktionsmodul (5) nach Anspruch 8 aufzunehmen, wobei das zusätzliche Funktionsmodul (5) Mittel zum Ausführen mindestens einer Funktion, die eine elektrische Versorgung erfordert, mindestens einen vierten Anschlusspol (6) und einen fünften Anschlusspol (7), die dazu geeignet sind, elektrisch mit dem ersten Anschlusspol (3) beziehungsweise mit dem zweiten Anschlusspol (4) des primären Funktionsmoduls (2) verbunden zu werden, um das zusätzliche Funktionsmodul (5) zu versorgen, beinhaltet, und dadurch, dass entweder die elektrische Ausrüstung (1') ein Unterbrechungselement umfasst, das dazu geeignet ist, auf die Unterbrechungsvorrichtung (2") einzuwirken, um den Fluss des Stroms zwischen dem ersten Anschlusspol (3) und dem zweiten Anschlusspol (4) zu unterbrechen, wenn das zusätzliche Funktionsmodul (5) in dem zweiten Aufnahmebereich (9') aufgenommen ist, oder ein Unterbrechungselement des zusätzlichen Funktionsmoduls (5) dazu geeignet ist, auf die Unterbrechungsvorrichtung (2") einzuwirken, um den Fluss des Stroms zwischen dem ersten Anschlusspol (3) und dem zweiten Anschlusspol (4) zu unterbrechen, wenn das zusätzliche Funktionsmodul (5) in dem zweiten Aufnahmebereich (9') aufgenommen ist.

2. Elektrische Ausrüstung nach Anspruch 1, **dadurch gekennzeichnet, dass** die Unterbrechungsvorrichtung (2") ferner einen Shunt (28) umfasst, der dazu geeignet ist, den Fluss des Stroms zwischen dem ersten Anschlusspol (3) und dem zweiten Anschlusspol (4) in einer ersten Stellung herzustellen, und dazu geeignet ist, durch das Unterbrechungselement von der ersten Stellung in eine zweite Stellung bewegt zu werden, wenn das zusätzliche Funktionsmodul (5) in dem zweiten Aufnahmebereich (9') aufgenommen ist, um den Fluss des Stroms zwischen dem ersten Anschlusspol (3) und dem zweiten Anschlusspol (4) zu unterbrechen.

3. Elektrische Ausrüstung nach Anspruch 1, **dadurch gekennzeichnet, dass** das Unterbrechungselement ein erstes Blockierelement ist, das dazu geeignet ist, die Unterbrechungsvorrichtung (2") in einer geöffneten Stellung zu blockieren, wenn das zusätzliche Funktionsmodul (5) in dem zweiten Aufnahmebereich (9') aufgenommen ist.

4. Elektrische Ausrüstung nach einem der Ansprüche 1 bis 3, **dadurch gekennzeichnet, dass** das primäre Funktionsmodul (2) mindestens eine erste Anschlussklemme (3'), die elektrisch mit dem ersten Anschlusspol (3) verbunden ist, und eine zweite Anschlussklemme (4'), die elektrisch mit dem zweiten Anschlusspol (4) verbunden ist, umfasst und dadurch, dass die erste Anschlussklemme (3') und die zweite Anschlussklemme (4') eine erste Buchse (13) bilden.

5. Elektrische Ausrüstung nach einem der Ansprüche 1 bis 4, **dadurch gekennzeichnet, dass** sie ferner ein Steuerorgan (2') umfasst, das dazu geeignet ist, auf die Unterbrechungsvorrichtung (2") einzuwirken, um einen Übergang aus der Öffnungsstellung der Unterbrechungsvorrichtung (2") in die Schließstellung der Unterbrechungsvorrichtung (2") zu ermöglichen und/oder um einen Übergang aus der Schließstellung der Unterbrechungsvorrichtung (2") in die Öffnungsstellung der Unterbrechungsvorrichtung (2") zu ermöglichen.

6. Elektrische Ausrüstung nach einem der Ansprüche 4 oder 5, **dadurch gekennzeichnet, dass** sie ein erstes Gehäuse (15) umfasst, mit dem die erste Buchse (13) und/oder das Steuerorgan (2') montiert sind.

7. Elektrische Ausrüstung nach Anspruch 6, **dadurch gekennzeichnet, dass** das Aufnahmemodul (8) einen Trägerrahmen (8') umfasst, der eine zentrale Öffnung (17) umfasst, die mindestens zum Teil den ersten und den zweiten Aufnahmebereich (9, 9') bildet, die das erste Gehäuse (15) aufnehmen, und dazu geeignet ist, ein zweites Gehäuse (16) des zusätzlichen Funktionsmoduls (5) aufzunehmen, und dadurch, dass das erste Gehäuse (15) lösbare Befestigungsmittel (18, 19) umfasst, die mit dem Trägerrahmen zusammenwirken.

8. Zusätzliches Funktionsmodul (5) für die elektrische Ausrüstung (1') nach einem der Ansprüche 1 bis 7, wobei das zusätzliche Funktionsmodul (5) die Mittel zur Ausführung mindestens der Funktion, die eine elektrische Versorgung benötigt, beinhaltet, **dadurch gekennzeichnet, dass** es dazu geeignet ist, in dem zweiten Aufnahmebereich (9') der elektrischen Ausrüstung (1') aufgenommen zu sein, wobei das zusätzliche Funktionsmodul (5) mindestens den vierten Anschlusspol (6) und den fünften Anschlusspol (7) umfasst, die dazu geeignet sind, jeweils mit dem ersten Anschlusspol (3) und dem zweiten Anschlusspol (4) des primären Funktionsmoduls (2) der elektrischen Ausrüstung (1') elektrisch verbunden zu sein, um das zusätzliche Funktionsmodul (5) zu versorgen, und dadurch, dass entweder das Unterbrechungselement des zusätzlichen Funktionsmoduls (5) dazu geeignet ist, auf die Unterbrechungsvorrichtung (2") einzuwirken, um den Fluss des Stroms zwischen dem ersten Anschlusspol (3) und dem zweiten Anschlusspol (4) zu unterbrechen, wenn das zusätzliche Funktionsmodul (5) in dem zweiten Aufnahmebereich (9') der elektrischen Ausrüstung (1') aufgenommen ist, oder das zusätzliche Funktionsmodul (5) dazu geeignet ist, auf das Unterbrechungselement der elektrischen Ausrüstung (1'), das auf die Unterbrechungsvorrichtung (2") einwirkt, einzuwirken, um den Fluss des Stroms zwischen dem ersten Anschlusspol (3) und dem zweiten Anschlusspol (4) zu unterbrechen, wenn das zusätzliche Funktionsmodul (5) in dem zweiten Aufnahmebereich (9') der elektrischen Ausrüstung (1') aufgenommen ist.

9. Zusätzliches Funktionsmodul nach Anspruch 8, **dadurch gekennzeichnet, dass** das Unterbrechungselement ein erstes Blockierelement ist, das dazu geeignet ist, die Unterbrechungsvorrichtung (2") in einer geöffneten Stellung zu blockieren, wenn das zusätzliche Funktionsmodul (5) in dem zweiten Aufnahmebereich (9') aufgenommen ist.

10. Zusätzliches Funktionsmodul nach einem der Ansprüche 8 oder 9, **dadurch gekennzeichnet, dass** die mindestens eine Funktion des zusätzlichen Funktionsmoduls (5) eine Funktion ist, die eine elektrische Versorgung erfordert, unter Ausschluss einer Kontrolllampenbeleuchtungsfunktion im Zusammenhang mit der Öffnungsstellung und/oder der Schließstellung der Unterbrechungsvorrichtung (2") des primären Funktionsmoduls (2).

11. Zusätzliches Funktionsmodul nach einem der Ansprüche 8 bis 10, **dadurch gekennzeichnet, dass** es mindestens eine vierte Anschlussklemme (6'), die elektrisch mit dem vierten Anschlusspol (6) verbunden ist, und eine fünfte Anschlussklemme (7'), die elektrisch mit dem fünften Anschlusspol (7) verbunden ist, umfasst und dadurch, dass die vierte Anschlussklemme (6') und die fünfte Anschlussklemme (4') eine zweite Buchse (14) bilden.

12. Zusätzliches Funktionsmodul nach einem der Ansprüche 8 bis 11, **dadurch gekennzeichnet, dass** die Funktion des zusätzlichen Funktionsmoduls (5) dazu geeignet und bestimmt ist, versorgt und aktiviert zu werden, wenn die Unterbrechungsvorrichtung (2") des primären Funktionsmoduls (2) in der Öffnungsstellung ist und/oder wenn der Shunt (28) in die zweite Stellung bewegt wird.

13. Zusätzliches Funktionsmodul nach einem der Ansprüche 8 bis 12, **dadurch gekennzeichnet, dass** es ferner ein zweites Blockierelement umfasst, das dazu geeignet ist, das Steuerorgan (2') in der geöffneten Stellung zu blockieren, wenn das zusätzliche Funktionsmodul (5) in dem zweiten Aufnahmebereich (9') der elektrischen Ausrüstung (1') aufgenommen ist.

14. Zusätzliches Funktionsmodul nach einem der Ansprüche 8 bis 13, **dadurch gekennzeichnet, dass** es eine Leiterplatte (10, 11) umfasst, die einen Messfühler und/oder Mittel zum Senden und/oder Empfangen von elektromagnetischen Wellen und/oder Anzeigemittel und/oder Betätigungsmittel und/oder Datenverarbeitungsmittel umfasst.

15. Elektrische Baugruppe (1), umfassend eine elektrische Ausrüstung (1') nach einem der Ansprüche 1 bis 7 und ein zusätzliches Funktionsmodul (5) nach einem der Ansprüche 8 bis 14, wobei das zusätzliche Funktionsmodul (5) in dem zweiten Aufnahmebereich (9') der elektrischen Ausrüstung (1') aufgenommen ist, wobei der vierte Anschlusspol (6) und der fünfte Anschlusspol (7) des zusätzlichen Funktionsmoduls mit dem ersten Anschlusspol (3) beziehungsweise mit dem zweiten Anschlusspol (4) des primären Funktionsmoduls (2) der elektrischen Ausrüstung (1') elektrisch verbunden sind, um das zusätzliche Funktionsmodul (5) zu versorgen, wobei das Unterbrechungselement auf die Unterbrechungsvorrichtung (2") einwirkt, um den Fluss des Stroms zwischen dem ersten Anschlusspol (3) und dem zweiten Anschlusspol (4) zu unterbrechen.

## Claims

1. Electrical apparatus (1') for an electrical installation, able and intended to be connected to an electrical grid, comprising at least:
- a reception module (8) comprising at least a first reception area (9);
- a primary functional module (2) received in the first reception area (9) and comprising a first connection pole (3) able and intended to be connected to a first line (L) of the electrical grid and a second connection pole (4) able and intended to be connected to a second line (L1) of an electrical circuit of the electrical installation,
the primary functional module (2) comprising a device (2") for interrupting the current, which device is arranged between the first connection pole (3) and the second connection pole (4) and is able, in an open position, to interrupt the current between the first connection pole (3) and the second connection pole (4) and, in a closed position, to allow the passage of the current between the first connection pole (3) and the second connection pole (4),
which electrical apparatus (1') is **characterized in that** the reception module comprises a second reception area (9') for receiving an additional functional module (5) according to Claim 8, said additional functional module (5) having means for performing at least one function requiring an electric power supply, at least a fourth connection pole (6) and a fifth connection pole (7) that are able to be electrically connected respectively to the first connection pole (3) and to the second connection pole (4) of the primary functional module (2) in order to supply power to the additional functional module (5), and **in that** either the electrical apparatus (1') comprises an interruption element able to act on the interruption device (2") so as to interrupt the flow of the current between the first connection pole (3) and the second connection pole (4) when the additional functional module (5) is received in the second reception area (9'), or an interruption element of the additional functional module (5) is able to act on the interruption device (2") so as to interrupt the flow of the current between the first connection pole (3) and the second connection pole (4) when the additional functional module (5) is received in the second reception area (9').

2. Electrical apparatus according to Claim 1, **characterized in that** the interruption device (2") furthermore comprises a shunt (28) able to establish the flow of the current between the first connection pole (3) and the second connection pole (4) in a first position and able to be moved from the first position to a second position by the interruption element when the additional functional module (5) is received in the second reception area (9') so as to interrupt the flow of the current between the first connection pole (3) and the second connection pole (4).

3. Electrical apparatus according to Claim 1, **characterized in that** the interruption element is a first blocking element able to block the interruption device (2") in an open position when the additional functional module (5) is received in the second reception area (9').

4. Electrical apparatus according to any one of Claims 1 to 3, **characterized in that** the primary functional module (2) comprises at least a first connection terminal (3') electrically connected to the first connection pole (3) and a second connection terminal (4') electrically connected to the second connection pole (4), and **in that** the first connection terminal (3') and the second connection terminal (4') form a first outlet (13).

5. Electrical apparatus according to any one of Claims 1 to 4, **characterized in that** it furthermore comprises a control member (2') able to act on the interruption device (2") so as to allow a change from the open position of the interruption device (2") to the closed position of the interruption device (2") and/or to allow a change from the closed position of the interruption device (2") to the open position of the interruption device (2").

6. Electrical apparatus according to either one of Claims 4 and 5, **characterized in that** it comprises a first housing (15) with which the first outlet (13) and/or the control member (2') are assembled.

7. Electrical apparatus according to Claim 6, **characterized in that** the reception module (8) comprises a support frame (8') comprising a central opening (17) at least partly forming said first and second reception areas (9, 9') receiving the first housing (15) and being able to receive a second housing (16) of the additional functional module (5), and **in that** the first housing (15) comprises removable fastening means (18, 19) interacting with the support frame.

8. Additional functional module (5) for said electrical apparatus (1') according to any one of Claims 1 to 7, the additional functional module (5) having the means for performing at least the function requiring an electric power supply, **characterized in that** it is able to be received in the second reception area (9') of the electrical apparatus (1'), the additional functional module (5) comprising at least the fourth connection pole (6) and the fifth connection pole (7) that are able to be electrically connected respectively to the first connection pole (3) and to the second connection pole (4) of the primary functional module (2) of the electrical apparatus (1') in order to supply power to the additional functional module (5), and **in that** either said interruption element of the additional functional module (5) is able to act on the interruption device (2") so as to interrupt the flow of the current between the first connection pole (3) and the second connection pole (4) when the additional functional module (5) is received in the second reception area (9') of the electrical apparatus (1'), or the additional functional module (5) is able to act on said interruption element of the electrical apparatus (1') acting on the interruption device (2") so as to interrupt the flow of the current between the first connection pole (3) and the second connection pole (4) when the additional functional module (5) is received in the second reception area (9') of the electrical apparatus (1').

9. Additional functional module according to Claim 8, **characterized in that** the interruption element is a first blocking element able to block the interruption device (2") in an open position when the additional functional module (5) is received in the second reception area (9').

10. Additional functional module according to either one of Claims 8 and 9, **characterized in that** said at least one function of the additional functional module (5) is a function requiring an electric power supply, excluding an indicator light lighting function linked to the open position and/or the closed position of the interruption device (2") of the primary functional module (2).

11. Additional functional module according to any one of Claims 8 to 10, **characterized in that** it comprises at least a fourth connection terminal (6') electrically connected to the fourth connection pole (6) and a fifth connection terminal (7') electrically connected to the fifth connection pole (7), and **in that** the fourth connection terminal (6') and the fifth connection terminal (4') form a second outlet (14).

12. Additional functional module according to any one of Claims 8 to 11, **characterized in that** the function of the additional functional module (5) is able and intended to be supplied with power and activated when the interruption device (2") of the primary functional module (2) is in the open position and/or when the shunt (28) is moved to the second position.

13. Additional functional module according to any one of Claims 8 to 12, **characterized in that** it furthermore comprises a second blocking element able to block the control member (2') in the open position when the additional functional module (5) is received in the second reception area (9') of the electrical apparatus (1').

14. Additional functional module according to any one of Claims 8 to 13, **characterized in that** it comprises an electronic card (10, 11) comprising a measurement sensor and/or electromagnetic wave transmission and/or reception means and/or display means and/or actuation means and/or data processing means.

15. Electrical assembly (1) comprising an electrical apparatus (1') according to any one of Claims 1 to 7 and an additional functional module (5) according to any one of Claims 8 to 14, said additional functional module (5) being received in the second reception area (9') of the electrical apparatus (1'), the fourth connection pole (6) and the fifth connection pole (7) of the additional functional module being electrically connected respectively to the first connection pole (3) and to the second connection pole (4) of the primary functional module (2) of the electrical apparatus (1') in order to supply power to the additional functional module (5), the interruption element acting on the interruption device (2") so as to interrupt the flow of the current between the first connection pole (3) and the second connection pole (4).
